# EUROPEAN PATENT SPECIFICATION

(11) **EP 4 228 383 B1**
(45) Date of publication and mention of the grant of the patent: **16.09.2026**
(21) Application number: 22847103.3
(22) Date of filing: 15.12.2022
(51) Int. Cl.: H05K 7/20, H05K 9/00, H10W 42/20, H10W 76/138, H10W 76/15, H10W 76/40

(54) **ELECTRONIC DEVICE COMPRISING SEMICONDUCTOR**
ELEKTRONISCHE VORRICHTUNG MIT HALBLEITER
DISPOSITIF ÉLECTRONIQUE COMPRENANT UN SEMI-CONDUCTEUR

(30) Priority: 30.12.2021 KR 20210193012; 04.02.2022 KR 20220014985
(43) Date of publication of application: 16.08.2023
(73) Proprietor: Samsung Electronics Co., Ltd., Suwon-si, Gyeonggi-do 16677 (KR)
(72) Inventor: SUNG, Jungoh, Suwon-si, Gyeonggi-do 16677 (KR); SON, Changjong, Suwon-si, Gyeonggi-do 16677 (KR); PARK, Min, Suwon-si, Gyeonggi-do 16677 (KR); AHN, Heecheol, Suwon-si, Gyeonggi-do 16677 (KR); HWANG, Jieun, Suwon-si, Gyeonggi-do 16677 (KR); KWAK, Dongyeol, Suwon-si, Gyeonggi-do 16677 (KR); KIM, Juho, Suwon-si, Gyeonggi-do 16677 (KR); JO, Wonbin, Suwon-si, Gyeonggi-do 16677 (KR)
(74) Representative: Gulde & Partner
(86) International application number: PCT/KR2022/020491
(87) International publication number: WO 2023/128423

(56) References cited:
- JP-A- 2002 261 484
- JP-A- 2018 182 162
- KR-A- 20180 123 168
- US-A- 6 097 602
- US-A1- 2003 085 475
- US-A1- 2014 078 677
- US-A1- 2017 110 384
- US-A1- 2017 188 448
- US-A1- 2021 161 039

## Description

### [Technical Field]

Various embodiments disclosed herein relate to an electronic device including a semiconductor.

### [Background Art]

A portable electronic device may include a semiconductor component (e.g., an application processor (which will be referred to as an "AP")) that implements various functions. Heat and electromagnetic waves (or noise) generated from the semiconductor component may cause malfunctions of components mounted in the electronic device or may cause electrical damage to the components. Accordingly, the electronic device may include a thermal interface material (which will be referred to as a "TIM") for transferring heat generated from a semiconductor component to another structure and a shield structure (e.g., a shield can or a shield sheet) for shielding electromagnetic waves generated from the semiconductor component.

US 2021161039 A1 discloses an electronic device including a circuit board, an electric component, a shielding sheet and a shield can. US 20030085475 A1 discloses semiconductor package having a dam. US 20170188448 A1 discloses an electronic device package with a barrier.

### [Disclosure]

### [Technical Problem]

In the process of applying the thermal interface material, the thermal interface material may partially escape to an area other than the area to which the thermal interface material is to be applied (e.g., an area in which a semiconductor component is not disposed). The partial escaping of the thermal interface material may cause a deviation in the glue spread of the thermal interface material or formation of an empty space (e.g., an air gap) between the thermal interface material and the shield sheet, thereby reducing the heat transfer efficiency of the electronic device. In addition, the escaping of the thermal interface material may reduce the bonding force between the shield sheet and the shield can.

### [Technical Solution]

The technical solution is defined in the appended claims.

An electronic device according to various embodiments of the disclosure includes: a circuit board; a shield can disposed on the circuit board and including an opening; a semiconductor component disposed in a space at least partially surrounded by the circuit board and the shield can; a shield sheet disposed to cover the opening and including a blocking material that blocks at least some of electromagnetic waves generated from the semiconductor component; a partition member disposed between the semiconductor component and the shield sheet, and a thermal interface material (TIM) disposed in a space at least partially surrounded by the semiconductor component, the partition member, and the shield sheet, wherein the partition member is configured to at least partially surround the space in which the thermal interface material is disposed, and wherein the partition member comprises at least one hole leading from an interior of the space in which the thermal interface material is disposed to an exterior of the space in which the thermal interface material is disposed.

A method of manufacturing an electronic device according to various embodiments of the disclosure includes: a process of disposing, on a circuit board, a semiconductor component and a shield can disposed to surround at least a portion of the semiconductor component and including an opening; a process of disposing a thermal interface material in at least a portion of the semiconductor component viewed in a direction in which the semiconductor component is viewed through the opening;; a process of disposing a partition member, which blocks at least a partial area of the semiconductor component in which the thermal interface material is disposed from at least a portion of an area in which the semiconductor component is not disposed, in the direction in which the semiconductor component is viewed through the opening, and a shield sheet that covers the opening; and a process of applying the thermal interface material to a space at least partially surrounded by the semiconductor component, the partition member, and the shield sheet by pressing at least a portion of the shield sheet corresponding to the area in which the thermal interface material is disposed, wherein the applying of the thermal interface material further comprises pressing at least a portion of the shield sheet corresponding to the area in which the thermal interface material is disposed so that at least some of the thermal interface material applied to the space is discharged from an interior of the space to an exterior of the space through at least one hole leading from the interior of the space to the exterior of the space.

### [Advantageous Effects]

According to various embodiments disclosed herein, it is possible to provide an electronic device, which includes a structure that blocks an area to which a thermal interface material is to be applied from an area other than the area to which the thermal interface material is to be applied, thereby preventing the thermal interface material from escaping to the area other than the area to which the thermal interface material is to be applied.

In addition, various effects directly or indirectly identified through the disclosure may be provided.

### [Description of Drawings]

FIG. 1 is a block diagram of an electronic device according to an embodiment in a network environment.
FIG. 2 is a plan view illustrating an electronic device including a semiconductor component according to an embodiment.
FIG. 3 is a cross-sectional view illustrating an electronic device including a partition member according to an embodiment.
FIG. 4 is a cross-sectional view illustrating an electronic device including a partition member according to an embodiment.
FIG. 5 is a plan view illustrating an electronic device including a partition member according to an embodiment.
FIG. 6 is a plan view illustrating an electronic device including a partition member according to an embodiment.
FIG. 7 is a plan view illustrating an electronic device including at least one accommodation portion.
FIG. 8 is a plan view illustrating an electronic device including a partition member according to an embodiment.
FIG. 9 is a flowchart illustrating a method of manufacturing an electronic device including a semiconductor component according to an embodiment.

In connection with the description of the drawings, the same or similar components may be denoted by the same or similar reference numerals.

### [Mode for Invention]

Hereinafter, various embodiments of the disclosure will be described with reference to the accompanying drawings.

An electronic device according to various embodiments of the disclosure may include at least one of, for example, a smartphone, a tablet personal computer (PC), a mobile phone, a video phone, an electronic book reader (e-book reader), a desktop PC, a laptop PC, a netbook computer, a workstation, a server, a personal digital assistant (PDA), a portable multimedia player (PMP), a MPEG-1 audio layer-3 (MP3) player, a mobile medical device, a camera, and a wearable device. The wearable device may include at least one of an accessory type (e.g., watch, ring, bracelet, anklet, necklace, glasses, contact lens, or head-mounted device (HMD)), a fabric or clothing-integrated type (e.g., electronic clothing), a body-mounted type (e.g., skin pad, or tattoo), and a bio-implantable type (e.g., implantable circuit).

In some embodiments, the electronic device may include at least one of, for example, a television, a digital video disk (DVD) player, an audio, a refrigerator, an air conditioner, a vacuum cleaner, an oven, a microwave oven, a washing machine, an air purifier, a set-top box, a home automation control panel, a security control panel, a TV box, a game console, an electronic dictionary, an electronic key, a camcorder, and an electronic photo frame.

In other embodiments, the electronic device may include at least one of various medical devices (e.g., various portable medical measuring devices (blood glucose monitoring device, heart rate monitoring device, blood pressure measuring device, body temperature measuring device, etc.), magnetic resonance angiography (MRA), magnetic resonance imaging (MRI), computed tomography (CT) machine, ultrasonic machine, etc.), a navigation device, a global positioning system (GPS) receiver, an event data recorder (EDR) , a flight data recorder (FDR) , a vehicle infotainment device, electronic equipment for a ship (e.g., ship navigation device, gyro-compass, etc.), avionics, a security device, an automobile head unit, a home or industrial robot, an automatic teller's machine (ATM) in banks, point of sales (POS) in a shop, or Internet of things devices (e.g., light bulb, various sensors, electric or gas meter, sprinkler device, fire alarm, thermostat, streetlamp, toaster, sporting goods, hot water tank, heater, boiler, etc.).

According to some embodiments, the electronic device may include at least one of a part of furniture or a building/structure, an electronic board, an electronic signature receiving device, a projector, and various kinds of measuring instruments (e.g., water meter, electric meter, gas meter, radio wave meter, etc.). In various embodiments, the electronic device may be a combination of one or more of the aforementioned various devices. According to some embodiments, the electronic device may a flexible electronic device. Further, the electronic device according to an embodiment of the disclosure is not limited to the aforementioned devices, and may include a new electronic device according to the development of technology.

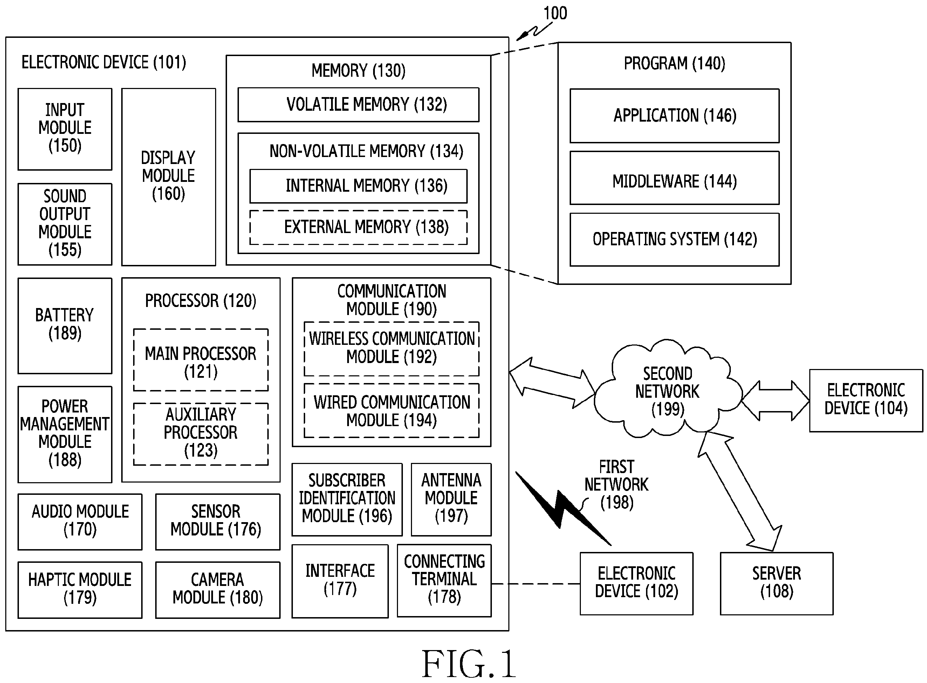

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control, for example, at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active (e.g., executing an application) state. According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence model is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or an external electronic device (e.g., an electronic device 102 (e.g., a speaker or a headphone)) directly or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly or wirelessly. According to an embodiment, the interface 177 may include, for example, a high definition multimedia interface (HDMI), a universal serial bus (USB) interface, a secure digital (SD) card interface, or an audio interface.

The connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 Gbps or more) for implementing eMBB, loss coverage (e.g., 164 dB or less) for implementing mMTC, or U-plane latency (e.g., 0.5 ms or less for each of downlink (DL) and uplink (UL), or a round trip of 1 ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments disclosed herein may be one of various types of electronic devices. The electronic devices may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that various embodiments of the disclosure and the terms used therein are not intended to limit the technological features set forth herein to particular embodiments and include various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "a first", "a second", "the first", and "the second" may be used to simply distinguish a corresponding element from another, and does not limit the elements in other aspect (e.g., importance or order). It is to be understood that if an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used herein, the term "module" may include a unit implemented in hardware, software, or firmware, and may be interchangeably used with other terms, for example, "logic," "logic block," "component," or "circuit". The "module" may be a minimum unit of a single integrated component adapted to perform one or more functions, or a part thereof. For example, according to an embodiment, the "module" may be implemented in the form of an application-specific integrated circuit (ASIC).

Various embodiments as set forth herein may be implemented as software (e.g., the program 140) including one or more instructions that are stored in a storage medium (e.g., the internal memory 136 or external memory 138) that is readable by a machine (e.g., the electronic device 101). For example, a processor (e.g., the processor 120) of the machine (e.g., the electronic device 101) may invoke at least one of the one or more stored instructions from the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may be separately disposed in any other element. According to various embodiments, one or more of the above-described elements may be omitted, or one or more other elements may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration. According to various embodiments, operations performed by the module, the program, or another element may be carried out sequentially, in parallel, repeatedly, or heuristically, or one or more of the operations may be executed in a different order or omitted, or one or more other operations may be added.

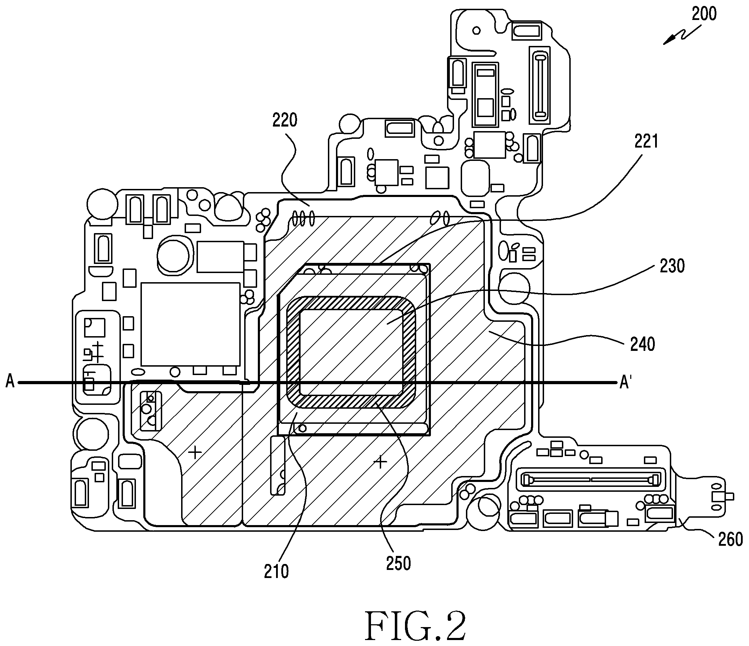

FIG. 2 is a plan view illustrating an electronic device 200 including a semiconductor component 210 according to an embodiment.

Referring to FIG. 2, the electronic device 200 may include: a semiconductor component 210 disposed on a circuit board 260; a shield can 220 surrounding at least a portion of the semiconductor component 210 and including an opening 221; a thermal interface material 230 configured to transfer heat generated from the semiconductor component 210 to another structure through the opening 221; a shield sheet 240 configured to cover the opening 221 to block electromagnetic waves (or noise) generated from the semiconductor component 210; and a partition member 250 configured to at least partially block a space in which the thermal interface material 230 is disposed from a space other than the space. However, the components of the electronic device 200 are not limited thereto. For example, the electronic device 200 may further include an accommodation portion configured to accommodate a portion of the thermal interface material 230.

According to an embodiment, the semiconductor component 210 may be disposed on the circuit board 260. The semiconductor component 210 may be operatively or electrically connected to the circuit board 260. According to an embodiment, the shield can 220 may be disposed to block electromagnetic waves (or noise) generated from the semiconductor component 210 or to protect the semiconductor component 210. For example, the shield can 220 may surround at least a portion of the semiconductor component 210 on the circuit board 260.

According to an embodiment, by disposing the shield can 220 on the circuit board 260, a space at least partially surrounded by the shield can 220 and the circuit board 260 may be defined. At least a portion of the semiconductor component 210 may be disposed inside the space. By disposing at least a portion of the semiconductor component 210 inside the space, the shield can 220 is able to block electromagnetic waves (or noise) generated from the semiconductor component 210 or to protect the semiconductor component 210 from an external impact.

According to an embodiment, the shield can 220 may include a metal material or a conductive material. For example, the shield can 220 may include at least one of iron, aluminum, or steel use stainless (SUS). However, the disclosure is not limited thereto. For example, the shield can 220 may include a blocking material that blocks electromagnetic waves (or noise) generated from the semiconductor component 210.

According to an embodiment, the shield can 220 may include at least one opening 221 in order to discharge heat generated from the semiconductor component 210 to the exterior of the space in which at least a portion of the semiconductor component 210 is disposed (e.g., the exterior of the shield can 220). The opening 221 may serve as a physical passage through which heat generated from the semiconductor component 210 is discharged to the exterior of the space in which at least a portion of the semiconductor component 210 is disposed. According to an embodiment, at least a portion of the semiconductor component 210 may be visible through the opening 221.

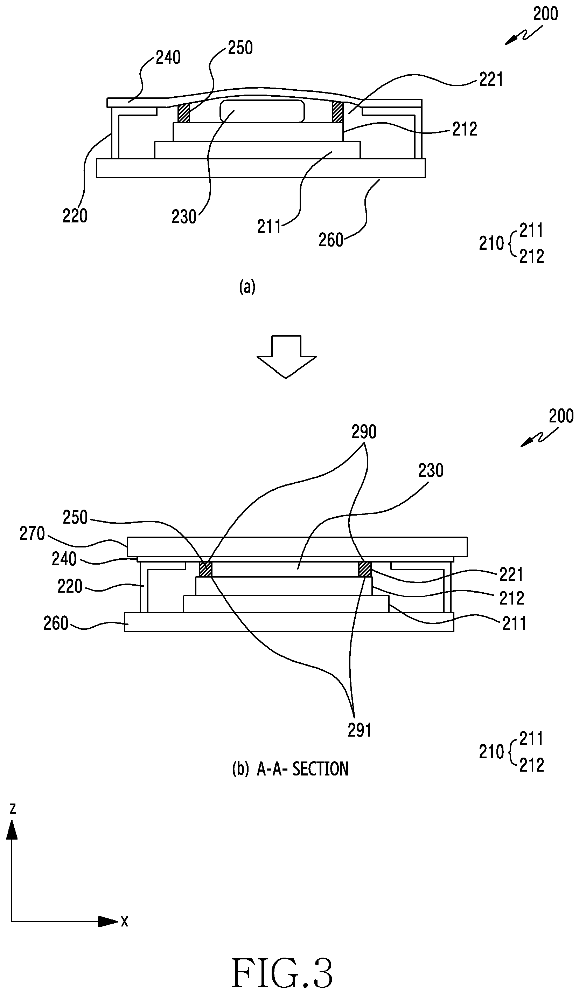

According to an embodiment, the electronic device 200 may include, for example, a thermal interface material (TIM) 230 configured to transfer heat generated from the semiconductor component 210 to another structure. The thermal interface material 230 may be disposed on at least a portion of the semiconductor component 210, which is visible in the direction viewed through the opening 221. The thermal interface material 230 may transfer heat generated from the semiconductor component 210 to the exterior of the shield can 220 through the opening 221. For example, the thermal interface material 230 may transfer the heat generated from the semiconductor component 210 to a structure (e.g., the structure 270 in FIG. 3) disposed outside the shield can 220 through the opening 221.

According to an embodiment, the shape of the opening 221 may change in correspondence with the size or shape of the semiconductor component 210. The opening 221 may include various shapes through which at least a portion of the semiconductor component 210 is visible through the opening 221. For example, the opening 221 may be smaller than the overall size of the semiconductor component 210, and may have the same size as the space in which the thermal interface material 230 is disposed or larger than the space in which the thermal interface material 230 is disposed. However, the disclosure is not limited thereto. For example, the opening 221 may include a plurality of holes.

According to an embodiment, the partition member 250 may be disposed along at least a portion of the periphery of the semiconductor component 210. FIG. 2 illustrates that only the sidewall of the partition member 250 entirely surround at least a portion of the semiconductor component 210, but the disclosure is not limited thereto. For example, the partition member 250 may further include a top surface extending from the side wall and disposed on at least a portion of the semiconductor component 210.

According to an embodiment, at least a portion of at least one surface of the partition member 250 may face the semiconductor component 210. For example, the partition member 250 may face at least a portion of at least one surface of the semiconductor component 210 that is visible in a direction in which the semiconductor component 210 is viewed through the opening 221. At least a portion of at least one surface of the partition member 250 may be bonded to the semiconductor component 210 by using an adhesive member.

According to the invention, the partition member 250 blocks at least a partial area of the semiconductor component 210 in which the thermal interface material 230 is disposed from an area in which the semiconductor component 210 is not disposed. For example, the partition member 250 may be disposed between the semiconductor component 210 and the shield sheet 240. The partition member 250 is disposed to at least partially surround at least a partial area of the semiconductor component 210 in which the thermal interface material 230 is disposed. By at least partially blocking at least a partial area of the semiconductor component 210 in which the thermal interface material 230 is disposed from the area in which the semiconductor component 210 is not disposed, the partition member 250 may prevent the thermal interface material 230 from moving (or escaping) to the exterior of the partition member 250 (e.g., the area in which the semiconductor component 210 is not disposed).

According to an embodiment, the shape of the partition member 250 may be a shape corresponding to at least a partial area of the semiconductor component 210 in which the thermal interface material 230 is disposed. For example, as illustrated in FIG. 2, when a partial area of the semiconductor component 210 in which the thermal interface material 230 is disposed has a quadrilateral shape when the partition member 250 is viewed from above, the partition member 250 may include a quadrilateral shape. However, the disclosure is not limited thereto. For example, the partition member 250 may have a polygonal, circular, or oval shape in a direction in which the partition member 250 is viewed through the opening 221.

According to an embodiment, the partition member 250 may include an oil-sorbent material. For example, the partition member 250 may include a porous material capable of absorbing the oil of the thermal interface material 230, such as a sponge.

According to an embodiment, the partition member 250 may include at least one of an elastic material and a thermally conductive material. By including the thermally conductive material, the partition member 250 may improve the heat transfer efficiency of the electronic device 200.

According to an embodiment, the shield sheet 240 may be disposed to block electromagnetic waves (or noise) generated from the semiconductor component 210. For example, the shield sheet 240 may cover at least a portion of the opening 221. According to an embodiment, at least a portion of the shield sheet 240 may be bonded to at least a portion of the shield can 220 provided with the opening 221. For example, at least a portion of the shield sheet 240 may be bonded to at least a portion of the shield can 220 provided with the opening 221, along the opening 221 by using an adhesive member. The adhesive member may include at least one of an adhesive tape or a glue. However, the disclosure is not limited thereto.

According to an embodiment, the shield sheet 240 may include a blocking material that at least partially blocks electromagnetic waves generated from the semiconductor component 210. For example, the shield sheet 240 may include microfibers (e.g., nanofibers). However, the disclosure is not limited thereto. Since the shield sheet 240 includes the blocking material, it is possible to prevent electromagnetic waves generated from the semiconductor component 210 from being discharged to the exterior of the shield can 220 through the opening 221.

According to an embodiment, the shield sheet 240 may face at least a portion of at least one surface of the partition member 250. For example, the shield sheet 240 may face at least a portion of one surface of the partition member 250 that is visible in the direction in which the partition member 250 is viewed through the opening 221. At least a portion of at least one surface of the partition member 250 may be bonded to the shield sheet 240 by using an adhesive member. However, the disclosure is not limited thereto. For example, the partition member 250 may be formed integrally with the shield sheet 240.

According to an embodiment, by covering at least a portion of the opening 221 with the shield sheet 240, a space at least partially surrounded by the semiconductor component 210, the partition member 250 and the shield sheet 240 may be defined. The thermal interface material 230 may be disposed in the space. For example, the thermal interface material 230 may be applied to the interior of the space to fill the space. The thermal interface material 230 applied to the space may transfer heat generated from the semiconductor component 210 to the exterior of the shield can 220 (e.g., to a structure disposed outside the shield can 220) via the shield sheet 240.

According to an embodiment, since the space surrounded by the semiconductor component 210, the partition member 250 and the shield sheet 240 is defined, a portion of the thermal interface material 230 disposed inside the space may not move (or escape) to the exterior of the space. For example, by preventing the thermal interface material 230 from partially moving to an area in which the semiconductor component 210 is not disposed, the partition member 250 may prevent the occurrence of a deviation in glue spread of the thermal interface material 230 or prevent the occurrence of an empty space (e.g., an air gap), which interrupts heat transfer, between the thermal interface material 230 and the shield sheet 240. In addition, by preventing the thermal interface material 230 from moving to the area between the shield can 220 and the shield sheet 240, the partition member 250 may prevent the thermal interface material 230 from weakening the bonding force between the shield can 220 and the shield sheet 240.

FIG. 3 is a cross-sectional view of an electronic device 200 including the partition member 250 according to an embodiment. (b) of FIG. 3B is a cross-sectional view taken along line A-A' of FIG. 2.

Regarding the semiconductor component 210, the shield can 220, the thermal interface material 230, the shield sheet 240, the partition member 250, and the circuit board 260 of FIG. 3, reference may be to the semiconductor component 210, the shield can 220, the thermal interface material 230, the shield sheet 240, the partition member 250, and the circuit board 260 of FIG. 2. The same reference numerals are used for the same or substantially the same components as those described above, and redundant descriptions are omitted.

According to an embodiment, the thermal interface material 230 may include a material having high mobility. For example, the thermal interface material 230 may be of a liquid or gel type. However, the disclosure is not limited thereto. According to an embodiment, the partition member 250 may prevent the thermal interface material 230 including a material having high mobility from overflowing into an area in which the semiconductor component 210 is not disposed.
(a) of FIG. 3 may be a view illustrating a state in which the thermal interface material 230 is disposed on at least a portion of the semiconductor component 210. (b) of FIG. 3 may be a view illustrating a state in which the thermal interface material 230 is applied to a space at least partially surrounded by the semiconductor component 210, the shield sheet 240, and the partition member 250.

According to an embodiment, the semiconductor component 210 may include a processor 211 (e.g., an AP, a CPU, or an electronic chip) disposed on the circuit board 260, and a memory device 212 disposed on one surface of the processor 211. However, the configuration of the semiconductor component 210 is not limited thereto. At least one of the above-mentioned components may be omitted from the semiconductor component 210 or the semiconductor component 210 may further include at least one component. For example, the semiconductor component 210 may further include a charger IC.

According to an embodiment, the processor 211 and the memory device 212 may be disposed in a space at least partially surrounded by the shield can 220 and the circuit board 260. For example, referring to FIG. 3, the shield can 220 may include: a front surface including an opening 221 and spaced apart from the circuit board 260; and a side surface extending toward the circuit board 260 (e.g., in the -z-axis direction) from the first surface and surrounding at least a portion of the space between the front surface and the circuit board 260. The processor 211 and the memory device 212 may be disposed inside a space at least partially surrounded by the circuit board 260 and the front surface and the side surface of the shield can 220. However, the shape of the shield can 220 is not limited thereto.

According to an embodiment, the memory device 212 may be disposed between the processor 211 and the shield sheet 240. For example, the memory device 212 may be disposed on one surface of the processor 211 that is visible in a direction (e.g., the -z-axis direction) in which the semiconductor component 210 is viewed through the opening 221.

According to an embodiment, the area of the one surface of the processor 211 that is visible through the opening 221 in the state in which the processor 211 is disposed may be larger than one surface of the memory device 212 that is visible through the opening 211 in the state in which the memory device 212 is disposed on the one surface of the processor 211. However, the disclosure is not limited thereto.

According to an embodiment, the partition member 250 may be disposed between the memory device 212 and the shield sheet 240. Referring to (a) of FIG. 3, the thermal interface material 230 may be disposed in the space at least partially surrounded by the memory device 212, the partition member 250, and the shield sheet 240.

According to an embodiment, referring to (b) of FIG. 3, the thermal interface material 230 may be applied to the interior of the space at least partially surrounded by the memory device 212, the partition member 250, and the shield sheet 240. For example, by coupling the circuit board 260 to the electronic device or disposing the structure 270 on the shield sheet 240, at least a partial area of the shield sheet 240 corresponding to the area in which the thermal interface material 230 is disposed may receive a compressive force in the direction in which the thermal interface material 230 is disposed (e.g., in the -z-axis direction). Since at least a partial area of the shield sheet 240 corresponding to the area in which the thermal interface material 230 is disposed receives a compressive force, the thermal interface material 230 may be applied to the space at least partially surrounded by the memory device 212, the partition member 250, and the shield sheet 240. The thermal interface material 230 may be applied to the interior of the space to fill the space. According to an embodiment, the structure 270 may be at least a portion of a housing of the electronic device, a vapor chamber, or a graphite heat dissipation sheet.

According to an embodiment, by applying the thermal interface material 230 to the space at least partially surrounded by the memory device 212, the partition member 250, and the shield sheet 240, the top surface of the thermal interface material 230 facing the shield sheet 240 may be flat. For example, the top surface of the applied thermal interface material 230 may overlap the shield sheet 240 in a horizontal direction (e.g., the x-axis direction). The top surface of the applied thermal interface material 230 may form the same level as the at least one surface of the partition member 250 that faces the shield sheet 240. However, the disclosure is not limited thereto.

According to an embodiment, by applying the thermal interface material 230 to the space at least partially surrounded by the memory device 212, the partition member 250, and the shield sheet 240 to fill the space, a deviation in the glue spread of the thermal interface material 230 may not occur. For example, an empty space (e.g., an air gap) may not be formed between the thermal interface material 230 and the shield sheet 240. Accordingly, the heat transfer efficiency of the electronic device 200 may be improved.

According to an embodiment, the partition member 250 may be disposed to surround at least a portion of an edge of the memory device 212 between the memory device 212 and the shield sheet 240. When the partition member 250 is disposed to surround at least a portion of an edge of the memory device 212, the area of the space to which the thermal interface material 230 is applied may increase. Accordingly, the heat transfer efficiency of the electronic device 200 may be improved.

According to an embodiment, at least a portion of at least one surface of the partition member 250 facing the shield sheet 240 may be bonded to at least a portion of at least one surface of the shield sheet 240 by using an adhesive member 290. By bonding at least a portion of the at least one surface of the partition member 250 to at least a portion of the at least one surface of the shield sheet 240, the adhesive member 290 may seal the gap between the space at least partially surrounded by the memory device 212, the partition member 250, and the shield sheet 240 and a space other than the space. The adhesive member 290 may prevent at least some of the thermal interface material 230 from leaking into the space between the partition member 250 and the shield sheet 240. However, the disclosure is not limited thereto. For example, the partition member 250 may be formed integrally with the shield sheet 240.

According to an embodiment, the adhesive member 290 may include a material having high resistance to the oil component of the thermal interface material 230. For example, the adhesive member 290 may include an antifouling material. However, the disclosure is not limited thereto.

According to an embodiment, the adhesive member 290 may include at least one of an adhesive tape or a bond. However, the disclosure is not limited thereto.

According to an embodiment, at least a portion of at least one surface of the partition member 250 may be bonded to at least a portion of at least one surface of the memory device 212 by using an adhesive member 291. By bonding at least a portion of the at least one surface of the partition member 250 to at least a portion of the at least one surface of the semiconductor component 210, the adhesive member 291 may seal the gap between the space at least partially surrounded by the memory device 212, the partition member 250, and the shield sheet 240 and a space other than the space. The adhesive member may prevent at least some of the thermal interface material 230 from leaking into the space between the partition member 250 and the semiconductor component 210.

According to an embodiment, the adhesive member 291 may include a material having high resistance to the oil component of the thermal interface material 230. For example, the adhesive member 291 may include an antifouling material. However, the disclosure is not limited thereto.

According to an embodiment, the adhesive member 291 may include at least one of an adhesive tape or a bond. However, the disclosure is not limited thereto.

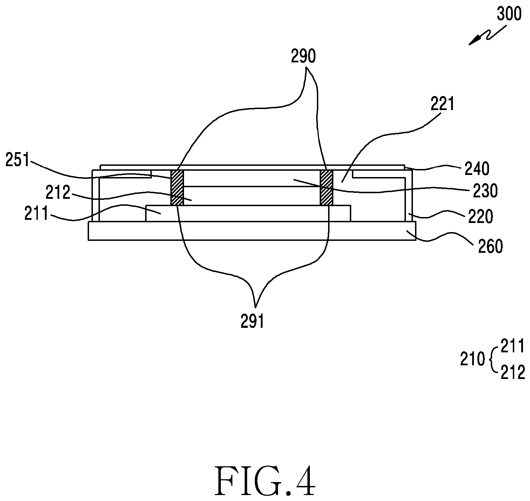

FIG. 4 is a cross-sectional view illustrating an electronic device 300 including a partition member 251 according to an embodiment.

Regarding the semiconductor component 210, the shield can 220, the thermal interface material 230, the shield sheet 240, and the circuit board 260 of FIG. 4, reference may be made to the semiconductor component 210, the shield can 220, the thermal interface material 230, the shield sheet 240, and the circuit board 260 of FIGS. 2 and 3. Regarding the partition member 251 of FIG. 4, reference may be made to the partition member 250 of FIG. 2. The same reference numerals are used for the same or substantially the same components as those described above, and redundant descriptions are omitted.

Referring to FIG. 4, the partition member 251 according to an embodiment may be disposed between the processor 211 and the shield sheet 240. For example, the partition member 251 may be disposed between one surface of the processor 211 on which the memory device 212 is disposed and the shield sheet 240.

According to an embodiment, the thermal interface material 230 may be disposed in a space at least partially surrounded by the processor 211, the partition member 251, and the shield sheet 240. The area of the space, which is defined by disposing the partition member 251 between the processor 211 and the shield sheet 240, and to which the thermal conductive material 230 is applied may be greater than the area of the space, which is defined by disposing the partition member 250 of FIG. 3 between the memory device 212 and the shield sheet 240, and to which the thermal interface material 230 is applied. Accordingly, the heat transfer efficiency of the electronic device 300 may be improved.

According to an embodiment, the partition member 251 may be disposed to surround at least a portion of the memory device 212. For example, the partition member 251 may be disposed to surround at least a portion of an outer periphery of the memory device 212. According to an embodiment, at least a portion of the partition member 251 (e.g., the inner surface of the wall of the partition member 251) may face the outer periphery of the memory device 212. When at least a portion of the partition member 251 faces the outer periphery of the memory device 212, the thermal interface material 230 may be disposed in the space at least partially surrounded by the memory device 212, the partition member 251, and the shield sheet 240.

According to an embodiment, at least a portion of at least one surface of the partition member 251 may be bonded to at least a portion of at least one surface of the shield sheet 240 by using an adhesive member 290. By bonding at least a portion of the at least one surface of the partition member 251 to at least a portion of the at least one surface of the shield sheet 240, the adhesive member 290 may seal the gap between the space at least partially surrounded by the memory device 212, the partition member 251, and the shield sheet 240 and a space other than the space. The adhesive member 290 may prevent the thermal interface material 230 from leaking into the space between the partition member 251 and the shield sheet 240. However, the disclosure is not limited thereto. For example, the partition member 251 may be formed integrally with the shield sheet 240.

According to an embodiment, the adhesive member 290 may include a material having high resistance to the oil component of the thermal interface material 230. For example, the adhesive member 290 may include an antifouling material. However, the disclosure is not limited thereto.

According to an embodiment, at least a portion of at least one surface of the partition member 251 may be bonded to at least a portion of at least one surface of the processor 211 by using an adhesive member 291. By bonding at least a portion of the at least one surface of the partition member 251 to at least a portion of the at least one surface of the semiconductor component 210, the adhesive member 291 may seal the gap between the space at least partially surrounded by the processor 211, the partition member 251, and the shield sheet 240 and a space other than the space. The adhesive member 291 may prevent the thermal interface material 230 from leaking into the space between the partition member 251 and the semiconductor component 210.

According to an embodiment, the adhesive member 291 may include a material having high resistance to the oil component of the thermal interface material 230. For example, the adhesive member 291 may include an antifouling material. However, the disclosure is not limited thereto.

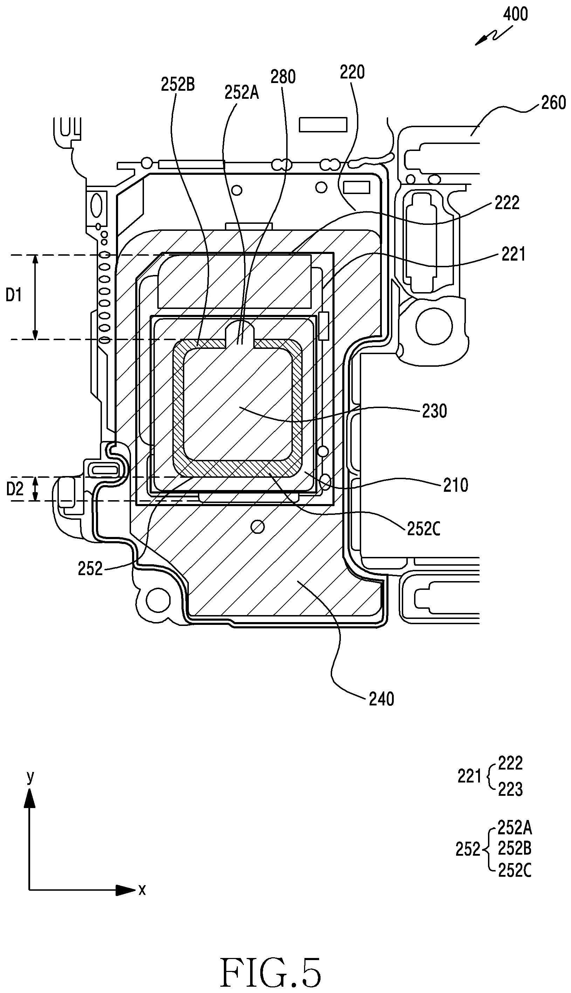

FIG. 5 is a plan view illustrating an electronic device 400 including a partition member 252 according to an embodiment.

Regarding the semiconductor component 210, the shield can 220, the thermal interface material 230, the shield sheet 240, and the circuit board 260 of FIG. 5, reference may be made to the semiconductor component 210, the shield can 220, the thermal interface material 230, the shield sheet 240, and the circuit board 260 of FIGS. 2 to 4. Regarding the partition member 252 of FIG. 5, reference may be made to the partition member 250 of FIGS. 2 and 3 or the partition member 251 of FIG. 4. The same reference numerals are used for the same or substantially the same components as those described above, and redundant descriptions are omitted.

Referring to FIG. 5, the electronic device 400 according to the invention includes at least one hole 280 leading from the interior of the space in which the thermal interface material 230 is disposed (e.g., the space at least partially surrounded by the partition member 252, the semiconductor component 210, and the shield sheet 240) to the exterior of the space in which the thermal interface material 230 is disposed.

According to an embodiment, when the amount of the thermal interface material 230 in the space is greater than the amount that can be accommodated by the space (for example, when the volume of the thermal interface material 230 disposed in the space is larger than the volume of the space), some of the thermal interface material 230 may be discharged from the interior of the space to the exterior of the space through at least one hole 280. For example, referring to FIG. 3, when a compressive force is applied to at least a partial area of the shield sheet 240 corresponding to the area in which the thermal interface material 230 is disposed in a direction in which the thermal interface material 230 (e.g., the -z-axis direction in FIG. 3) and thus the thermal interface material 230 is applied, some of the thermal interface material 230 may be discharged from the interior of the space to the exterior of the space through the at least one hole 280. Accordingly, the amount of the thermal interface material applied to the interior of the space is adjustable.

According to an embodiment, the partition member 252 may be spaced apart from the opening 221 by a predetermined distance. For example, at least one wall (e.g., the first wall 252B) of the partition member 252 may be spaced apart from at least one end (e.g., the one end 222) of the opening 221 by a predetermined distance. According to an embodiment, the at least one hole 280 may be opened toward an area in which the partition member 252 and the shield can 220 are spaced apart from each other by a predetermined distance.

According to an embodiment, the partition member 252 may include at least one slit 252A provided in at least one wall (e.g., the first wall 252B) of the partition member 252. The at least one hole 280 may be a space surrounded by at least one slit 252A, the semiconductor component 210, and the shield sheet 240 by disposing the semiconductor component 210, the partition member 252, and the shield sheet 240. However, the disclosure is not limited thereto. For example, the at least one hole 280 may be at least one through hole formed in at least one wall (e.g., the first wall 252B) of the partition member 252.

According to an embodiment, at least one slit 252A (which may be defined as a through hole when the at least one hole 280 according to an embodiment is formed in at least one wall of the partition member 252) may be formed in at least one wall 252B of the partition member 252 that is spaced apart from at least one end 222 by a predetermined distance when the semiconductor component 210 is viewed through the opening 221.

According to an embodiment, the at least one slit 252A (which may be defined as a through hole when the at least one hole 280 according to an embodiment is formed in at least one wall of the partition member 252) may be formed in one wall of the partition member 252 at a position that is spaced apart from one end of the opening 221 by a farther distance when the semiconductor component 210 is viewed through the opening 221. For example, referring to FIG. 5, when the semiconductor component 210 is viewed through the opening 221, the partition member 252 may include a first wall 252B disposed at a position spaced apart by a first distance D1 from one end 222 of the opening 221, and a second wall 252C disposed at a position spaced apart from the other end 223 of the opening 221 by a second distance D2 shorter than the first distance D1. In this case, at least one slit 252B may be formed in the first wall 252B.

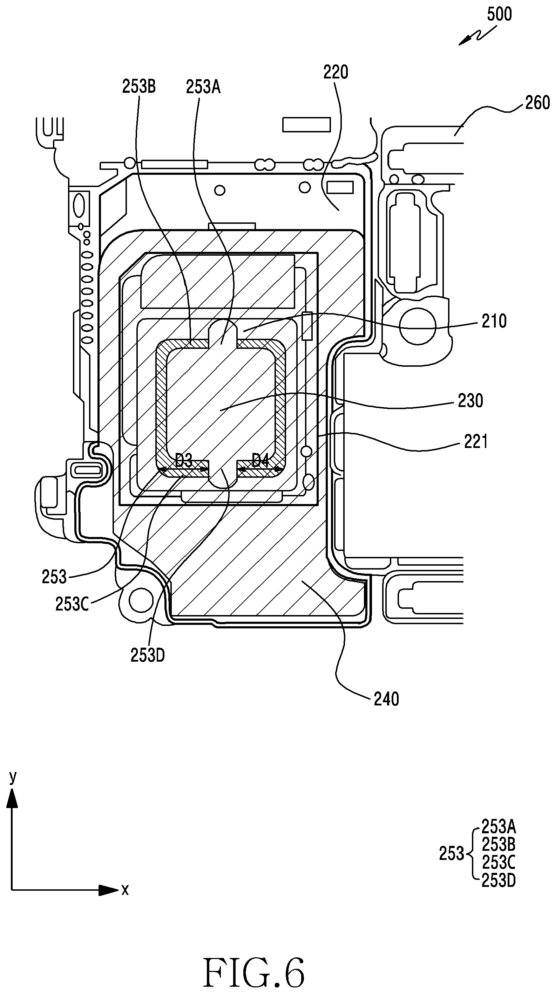

FIG. 6 is a plan view illustrating an electronic device 500 including a partition member 253 according to an embodiment.

Regarding the semiconductor component 210, the shield can 220, the thermal interface material 230, the shield sheet 240, and the circuit board 260 of FIG. 6, reference may be made to the semiconductor component 210, the shield can 220, the thermal interface material 230, the shield sheet 240, and the circuit board 260 of FIGS. 2 to 4. Regarding the partition member 253 of FIG. 6, reference may be made to the partition member 250 of FIGS. 2 and 3, the partition member 251 of FIG. 4, or the partition member 252 of FIG. 5. The same reference numerals are used for the same or substantially the same components as those described above, and redundant descriptions are omitted.

Referring to FIG. 6, the partition member 253 according to an embodiment may include a first wall 253B and a second wall 253C facing the first wall 253B. The first wall 253B and the second wall 253C may include at least one slit. For example, the first wall 253B may include a first slit 253A, which is opened in a first direction (e.g., the +y-axis direction). The second wall 253C may include a second slit 253D, which is opened in a second direction (e.g., the -y-axis direction) opposite to the first direction.

According to an embodiment, the shape of the first wall 253B may be symmetrical to the shape of the second wall 253C with respect to the space in which the thermal interface material 230 is disposed. The first slit 253A provided in the first wall 253B may be symmetrical to the second slit 253D provided in the second wall 253C. For example, the length of the width of the first slit 253A may be the same as the length of the width of the second slit 253D. In an example, the position at which the first slit 253A is provided may be symmetrical to the position at which the second slit 253D is provided with respect to the space in which the thermal interface material 230 is disposed.

According to an embodiment, the at least one slit (e.g., the first slit 253A) may be disposed in the center of at least one wall (e.g., the first wall 253B) in the longitudinal direction (e.g., the x-axis direction). For example, the partition member 253 may have a first length D3 from at least one slit 253A to one end of at least one wall 253B, and a second length D4 from the at least one slit 253A to the other end of the at least one wall 253B. The first length D3 may be the same as the second length D4. However, the disclosure is not limited thereto.

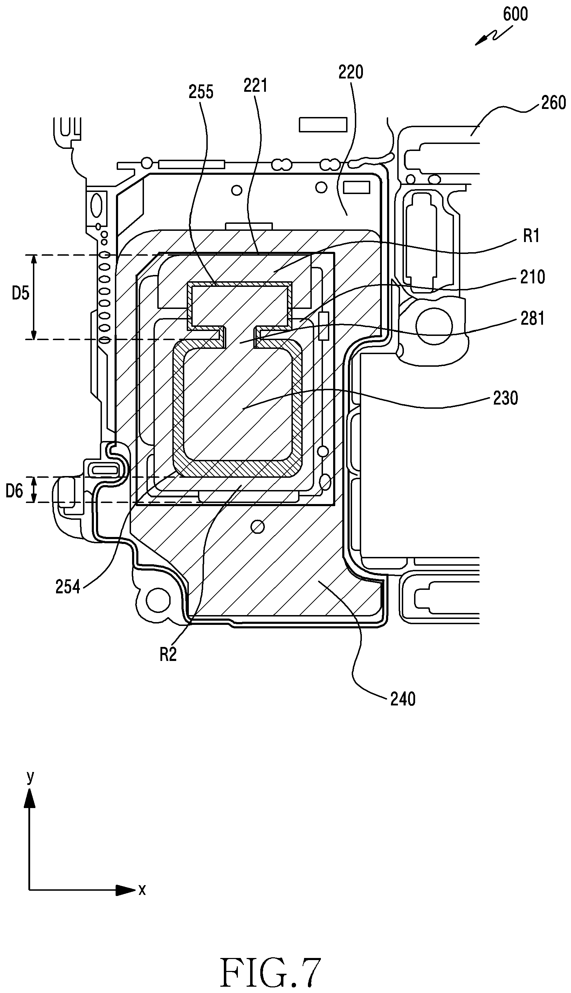

FIG. 7 is a plan view illustrating an electronic device 600 including an accommodation portion 255.

Regarding the semiconductor component 210, the shield can 220, the thermal interface material 230, the shield sheet 240, and the circuit board 260 of FIG. 7, reference may be made to the semiconductor component 210, the shield can 220, the thermal interface material 230, the shield sheet 240, and the circuit board 260 of FIGS. 2 to 4. Regarding the partition member 254 of FIG. 7, reference may be made to the partition member 250 of FIGS. 2 and 3 or the partition member 251 of FIG. 4. The same reference numerals are used for the same or substantially the same components as those described above, and redundant descriptions are omitted.

Referring to FIG. 7, the electronic device 600 according to an embodiment may further include at least one accommodation portion 255 configured to accommodate a portion of the thermal interface material 230. The at least one accommodation portion 255 may be disposed in an area (e.g., a first area R1) other than the space at least partially surrounded by the semiconductor component 210, the partition member 254, and the shield sheet 240. The at least one accommodation portion 255 may be connected to the space at least partially surrounded by the semiconductor component 210, the partition member 254, and the shield sheet 240. For example, the at least one accommodation portion 255 may be connected to the space through at least one hole 281 (reference may be made to the at least one hole 280 in FIG. 5).

According to an embodiment, the at least one accommodation portion 255 may accommodate a portion of the thermal interface material 230 disposed in the space at least partially surrounded by the semiconductor component 210, the partition member 254, and the shield sheet 240. For example, when the amount of the thermal interface material 230 in the space at least partially surrounded by the semiconductor component 210, the partition member 254, and the shield sheet 240 is greater than the amount that can be accommodated by the space (for example, when the volume of the thermal interface material 230 disposed in the space is greater than the volume of the space), some of the thermal interface material 230 may be disposed in the at least one accommodation portion 255.

According to an embodiment, at least some of the thermal interface material 230 may be discharged to the at least one accommodation portion 255 from the interior of the space through the at least one hole 281. For example, referring to FIG. 3, when a compressive force is applied to at least a partial area of the shield sheet 240 corresponding to the area in which the thermal interface material 230 is disposed in a direction in which the thermal interface material 230 (e.g., the -z-axis direction in FIG. 3) and thus the thermal interface material 230 is applied, some of the thermal interface material 230 may be discharged from the interior of the space to the at least one accommodation portion 255 through the at least one hole 281. Accordingly, the amount of the thermal interface material 230 applied to the interior of the space is adjustable.

According to an embodiment, an area other than the space at least partially surrounded by the semiconductor component 210, the partition member 254, and the shield sheet 240 may include a first area R1 and a second area R2. The first area R1 may have a first distance D5 from the partition member 254 to one end of the opening 221. The second area R2 may have a first distance D6 from the partition member 254 to the other end of the opening 221. According to an embodiment, the first distance D5 may be shorter than the second distance D6.

According to an embodiment, the at least one accommodation portion 255 may be disposed in an area having a greater distance from the partition member 254 to one end of the opening 221. For example, the at least one accommodation portion 255 may be disposed in the first area R1 having the first distance D5.

According to an embodiment, the electronic device 600 may include a first accommodation portion 255 disposed in a first direction (e.g., the y-axis direction) from the space at least partially surrounded by the semiconductor component 210, the partition member 254, and the shield sheet 240. Although not illustrated in FIG. 7, the electronic device 600 may include a second accommodation portion (not illustrated) disposed in a second direction (e.g., the -y-axis direction) opposite to the first direction from the space.

According to an embodiment, the first accommodation portion 255 may be symmetrical to the second accommodation portion. For example, the shape of the first accommodation portion 255 may be the same as the shape of the second accommodation portion. However, the disclosure is not limited thereto. For example, the position at which the first accommodation portion 255 is disposed may be symmetrical to the position at which the space at least partially surrounded by the semiconductor component 210, the partition member 254, and the shield sheet 240 is disposed.

FIG. 7 illustrates that the at least one accommodation portion 255 has a quadrilateral shape in a direction viewed through the opening 221, but the shape of the at least one accommodation portion 255 is not limited thereto. For example, the at least one accommodation portion 255 may have a polygonal or circular shape in the direction viewed through the opening 221.

According to an embodiment, the at least one accommodation portion 255 may have the shape of a housing or a groove that is capable of accommodating a portion of the thermal interface material 230. For example, the at least one accommodation portion 255 may include a front surface, a rear surface spaced apart from the front surface by a predetermined distance, and a side surface surrounding the space between the front surface and the rear surface. In an example, the at least one accommodation portion 255 may include only the rear surface and the side surface while the front surface is omitted. According to an embodiment, the at least one accommodation portion 255 may be formed as a space surrounded by an additional partition member extending from the partition member 254, the semiconductor component 210, and the shield sheet 240.

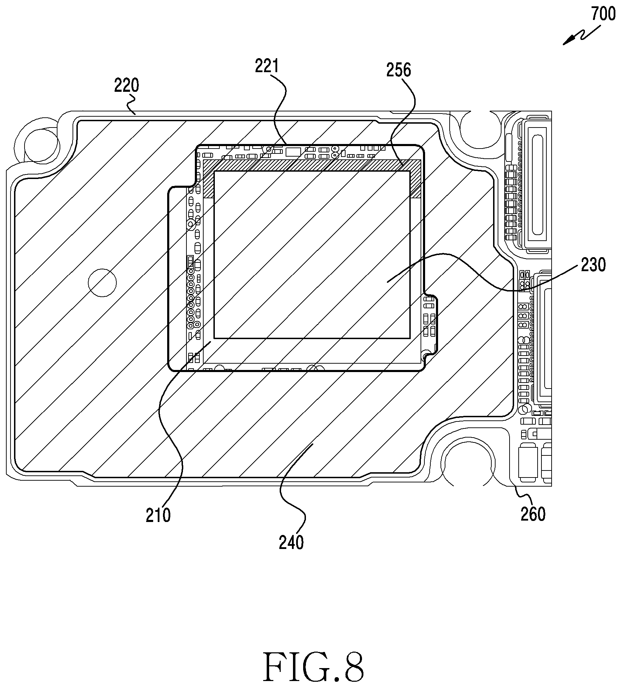

FIG. 8 is a plan view illustrating an electronic device 700 including a partition member 256 according to an embodiment.

Regarding the semiconductor component 210, the shield can 220, the thermal interface material 230, the shield sheet 240, and the circuit board 260 of FIG. 8, reference may be made to the semiconductor component 210, the shield can 220, the thermal interface material 230, the shield sheet 240, and the circuit board 260 of FIGS. 2 to 8. Regarding the partition member 256 of FIG. 8, reference may be made to the partition member 250 of FIGS. 2 and 3, the partition member 251 of FIG. 4, the partition member 252 of FIG. 5, the partition member 253 of FIG. 6, or the partition member 254 of FIG. 7. The same reference numerals are used for the same or substantially the same components as those described above, and redundant descriptions are omitted.

The partition member 256 according to an embodiment may be disposed adjacent to an area having a weak adhesive force between the shield sheet 240 and the shield can 220. For example, referring to FIG. 8, the partition member 256 may be disposed adjacent to an area having a small area of the shield sheet 240 bonded to the shield can 220. In an example, the partition member 256 may be disposed in an area having a short distance from one end of the opening 221. According to an embodiment, the partition member 256 may be disposed on one surface of the semiconductor component 210. For example, the partition member 256 may be disposed in an area having a short distance between the semiconductor component 210 and the shield can 220 (or one end of the opening 221). In some embodiments, the partition member 256 may be in contact with the shield can 220 (or one end of the opening 221).

According to an embodiment, an area in which the partition member 256 is disposed may vary. For example, a position at which the partition member 256 is disposed or an area in which the partition member 256 is disposed may vary. For example, although the partition member 256 of FIG. 8 is illustrated as having a shape surrounding at least a portion of one surface and opposite side surfaces of the semiconductor component 210, the shape of the partition member 256 is not limited to that of FIG. 8. For example, the partition member 256 may include a shape that shields at least a portion of the one surface of the semiconductor component 210. In an example, the partition member 256 may include a shape surrounding at least a portion of the one surface and one side surface of the semiconductor component 210.

According to an embodiment, by regulating the position or area of the area in which the partition member 256 is disposed, the amount of the thermal interface material 230 to be applied may be adjusted, or the position or area of the area to which the thermal interface material 230 is applied may be adjusted.

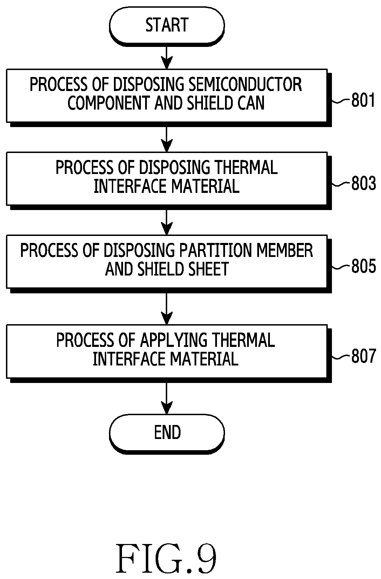

FIG. 9 is a flowchart illustrating a method of manufacturing an electronic device including a semiconductor component according to an embodiment.

Regarding the semiconductor component, the shield can, the thermal interface material, the shield sheet, and the circuit board of FIG. 9, reference may be made to the semiconductor component 210, the shield can 220, the thermal interface material 230, the shield sheet 240, and the circuit board 260 of FIGS. 2 to 8. Regarding the partition member of FIG. 9, reference may be made to the partition member 250 of FIGS. 2 and 3, the partition member 251 of FIG. 4, the partition member 252 of FIG. 5, the partition member 253 of FIG. 6, the partition member 254 of FIG. 7, or the partition member 256 of FIG. 8. The same reference numerals are used for the same or substantially the same components as those described above, and redundant descriptions are omitted.

Referring to FIG. 9, a method of manufacturing an electronic device according to an embodiment may include: a process of disposing a semiconductor component and a shield can (801); a process of disposing a thermal interface material (803); a process of disposing a partition member and a shield sheet (805); and a process of disposing a thermal interface material (807). However, the method of manufacturing an electronic device is not limited thereto. For example, at least one of the above-mentioned processes may be omitted from the method of manufacturing an electronic device, or the method may further include at least one process. For example, the method of manufacturing an electronic device may further include a process of discharging a portion of the thermal interface material (not illustrated) in the process of applying the thermal interface material (807).

According to an embodiment, in process (801), the semiconductor component may be disposed on a circuit board (the circuit board 260 of FIG. 1). According to an embodiment, the shield can including an opening may be disposed on the circuit board 260. The shield can may be disposed to surround at least a portion of the semiconductor component. In a direction in which the semiconductor component is viewed through the opening, at least a portion of the semiconductor component may be visible.

According to an embodiment, in process (803), the thermal interface material may be disposed on at least a portion of the semiconductor component. For example, the thermal conductive material may be disposed on at least a portion of the semiconductor component that is visible in the direction in which the semiconductor component is viewed through the opening.

According to an embodiment, in process (805), the partition member may be disposed on the semiconductor component. At least a portion of the partition member may face at least a portion of the semiconductor component. The partition member may be disposed to block at least a portion of an area in which a semiconductor component including at least a portion of a semiconductor component on which a thermal interface material is disposed in a direction in which the semiconductor component is viewed through the opening, from at least a portion in which the semiconductor component is not disposed. According to an embodiment, the shield sheet may cover the opening. The shield sheet may block electromagnetic waves (or noise) generated from the semiconductor component by covering the opening.

According to an embodiment, in process (805), the partition member and the shield sheet may be disposed to form a space at least partially surrounded by the semiconductor component, the partition member, and the shield sheet. A thermal interface material may be disposed inside the space.

According to an embodiment, in process (805), the partition member and the shield sheet may be disposed in the state in which the partition member is bonded to the shield sheet. For example, at least a portion of at least one surface of the partition member may be bonded to the shield sheet by using an adhesive member. In an example, the partition member may be formed integrally with the shield sheet. By disposing the partition member and the shield sheet in a state in which the partition member is bonded to the shield sheet, productivity of the method of manufacturing an electronic device may be improved. However, the disclosure is not limited thereto. According to an embodiment, in process (805), the shield sheet may be disposed in the state in which the partition member is bonded to at least a portion of at least one surface of the semiconductor component.

According to an embodiment, in process (807), by pressing at least a portion of the shield sheet corresponding to the area in which the thermal interface material is disposed, the thermal interface material may be applied to the space at least partially surrounded by the semiconductor component, the partition member, and the shield sheet. The thermal interface material may be applied to fill the space.

According to an embodiment, the electronic device may include at least one hole leading from the interior of the space at least partially surrounded by the semiconductor component, the partition member, and the shield sheet, to the exterior of the space. According to an embodiment, process (807) may further include a process of discharging some of the thermal interface material from the interior of the space to the exterior of the space through the at least one hole. According to an embodiment, in the process of discharging some of the thermal interface material, in the case where the amount of the thermal interface material applied to the space is greater than the amount that can be accommodated by the space, when at least a portion of the shield sheet corresponding to the area in which the thermal interface material is disposed is pressed and the thermal interface material is applied, some of the thermal interface material may be discharged from the interior of the space through the at least one hole. Accordingly, the amount of the thermal interface material applied to the interior of the space is adjustable.

As described above, the electronic device according to an embodiment includes: a circuit board; a shield can disposed on the circuit board and including an opening; a semiconductor component disposed in a space at least partially surrounded by the circuit board and the shield can; a shield sheet disposed to cover the opening and including a blocking material that blocks at least some of electromagnetic waves generated from the semiconductor component; a partition member disposed between the semiconductor component and the shield sheet, and configured to block at least a portion of an area in which the semiconductor component is disposed from an area in which the semiconductor component is not disposed in a direction in which the semiconductor component is viewed through the opening; and a thermal interface material disposed in a space at least partially surrounded by the semiconductor component, the partition member, and the shield sheet.

In an embodiment, the semiconductor component may include a processor disposed on the circuit board, and a memory device disposed between the processor and the shield sheet, the partition member may be disposed between the memory device and the shield sheet, and the thermal interface material may be disposed in the space at least partially surrounded by the memory device, the partition member, and the shield sheet.

According to an embodiment, the partition member may be disposed to surround at least a portion of an edge of the memory device.

According to an embodiment, the semiconductor component may include a processor disposed on the circuit board, and a memory device disposed between the processor and the shield sheet, the partition member may be disposed to surround at least a portion of an outer periphery of the memory device between one surface of the processor on which the memory device is disposed and the shield sheet, and the thermal interface material may be disposed in the space at least partially surrounded by the memory device, the partition member, and the shield sheet.

According to an embodiment, the electronic device may include at least one hole leading from an interior of the space in which the thermal interface material is disposed to an exterior of the space in which the thermal interface material is disposed.

According to an embodiment, the partition member may include at least one slit provided in at least one wall of the partition member, and the at least one hole may be provided by being surrounded by the semiconductor component, the at least one slit, and the shielding sheet.

According to an embodiment, the partition member may include: a first wall disposed at a position separated by a first distance from one end of the opening when the semiconductor component is viewed through the opening; and a second wall disposed at a position spaced apart from another end of the opening by a second distance closer than the first distance when the semiconductor component is viewed through the opening, and wherein the first wall may include the at least one slit.

According to an embodiment, the at least one slit may include: a first slit provided in the at least one wall; and a second slit provided in a wall facing the at least one wall.

According to an embodiment, the partition member may have a first length from the at least one slit to one end of the at least one wall, and a second length from the at least one slit to another end of the at least one wall, and the first length may be equal to the second length.

According to an embodiment, the electronic device may include at least one accommodation portion connected to the space in which the thermal interface material is disposed, and configured to accommodate a portion of the thermal interface member.

According to an embodiment, an area other than the space in which the thermal interface material is disposed may include a first area and a second area having a shorter distance from the partition member to one end of the opening compared to the first area, and the at least one accommodation portion may be disposed in the first area.

According to an embodiment, the at least one accommodation may include: a first accommodation portion disposed in a first direction from the space in which the thermal interface material is disposed; and a second accommodation portion disposed in a second direction opposite to the first direction from the space in which the thermal interface material is disposed.

According to an embodiment, the partition member may include at least one of a porous material or an oil-sorbent material.

According to an embodiment, the partition member may include at least one of a thermally conductive material or an elastic material.

According to an embodiment, at least a portion of at least one surface of the partition member may be bonded to at least a portion of at least one surface of the semiconductor component by using an adhesive member.

According to an embodiment, the adhesive member may include an antifouling material.

According to an embodiment, at least a portion of at least one surface of the partition member may be bonded to at least a portion of at least one surface of the shield sheet by using an adhesive member.

According to an embodiment, the adhesive member may include an antifouling material.

As described above, a method of manufacturing an electronic device according to an embodiment includes: a process of disposing, on a circuit board, a semiconductor component and a shield can disposed to surround at least a portion of the semiconductor component and including an opening; a process of disposing a thermal interface material in at least a portion of the semiconductor component viewed in a direction in which the semiconductor component is viewed through the opening; a process of disposing a partition member, which blocks at least a portion of an area in which the semiconductor component including at least a portion of the semiconductor component on which the thermal interface material is disposed from at least a portion of an area in which the semiconductor component is not disposed, in the direction in which the semiconductor component is viewed through the opening, and a shield sheet that covers the opening; and a process of applying the thermal interface material to a space at least partially surrounded by the semiconductor component, the partition member, and the shield sheet by pressing at least a portion of the shield sheet corresponding to the area in which the thermal interface material is disposed.

According to an embodiment, the process of applying the thermal interface material may further include: a process of pressing at least a portion of the shield sheet corresponding to the area in which the thermal interface material is disposed so that at least some of the thermal interface material applied to the space is discharged from an interior of the space to an exterior of the space through at least one hole leading from the interior of the space to the exterior of the space.

## Claims

1. An electronic device (100) comprising:
a circuit board (260);
a shield can (220) disposed on the circuit board (260) and including an opening (221);
a semiconductor component (210) disposed in a space at least partially surrounded by the circuit board (260) and the shield can (220);
a shield sheet (240) disposed to cover the opening (221) and including a blocking material that blocks at least some of electromagnetic waves generated from the semiconductor component (210);
a partition member (250) disposed between the semiconductor component (210) and the shield sheet (240), and
a thermal interface material, TIM (230), disposed in a space at least partially surrounded by the semiconductor component (210), the partition member (250), and the shield sheet (240),
wherein the partition member (250) is configured to at least partially surround the space in which the TIM (230) is disposed, and
wherein the partition member (250) comprises at least one hole leading from an interior of the space in which the TIM (230) is disposed to an exterior of the space in which the TIM (230) is disposed.

2. The electronic device (100) of claim 1, wherein the semiconductor component (210) comprises a processor disposed on the circuit board (260), and a memory device disposed between the processor and the shield sheet (240),
the partition member (250) is disposed between the memory device and the shield sheet (240), and
the TIM (230) is disposed in the space at least partially surrounded by the memory device, the partition member (250), and the shield sheet (240).

3. The electronic device (100) of claim 2, wherein the partition member (250) is disposed to surround at least a portion of an edge of the memory device.

4. The electronic device (100) of claim 1, wherein the semiconductor component (210) comprises a processor disposed on the circuit board (260), and a memory device disposed between the processor and the shield sheet (240),
the partition member (250) is disposed to surround at least a portion of an outer periphery of the memory device between one surface of the processor on which the memory device is disposed and the shield sheet (240), and
the TIM (230) is disposed in the space at least partially surrounded by the memory device, the partition member (250), and the shield sheet (240).

5. The electronic device (100) of claim 1, wherein the partition member (250) comprises at least one slit provided in at least one wall of the partition member (250), and
the at least one hole is formed by being surrounded by the semiconductor component (210), the at least one slit, and the shield sheet (240).

6. The electronic device (100) of claim 5, wherein the partition member (250) comprises:
a first wall disposed at a position separated by a first distance from one end of the opening (221) when the semiconductor component (210) is viewed through the opening (221); and
a second wall disposed at a position spaced apart from another end of the opening (221) by a second distance closer than the first distance when the semiconductor component (210) is viewed through the opening (221), and
wherein the first wall comprises the at least one slit.

7. The electronic device (100) of claim 5, wherein the at least one slit comprises:
a first slit provided in the at least one wall; and
a second slit provided in a wall facing the at least one wall.

8. The electronic device (100) of claim 5, wherein the partition member (250) has a first length from the at least one slit to one end of the at least one wall, and a second length from the at least one slit to another end of the at least one wall, and
the first length is equal to the second length.

9. The electronic device (100) of claim 1, further comprising at least one accommodation portion (255) connected to the space in which the TIM (230) is disposed and configured to accommodate a portion of the TIM (230).

10. The electronic device (100) of claim 9, wherein an area other than the space in which the TIM (230) is disposed comprises a first area and a second area having a shorter distance from the partition member (250) to one end of the opening (221) than the first area, and
the at least one accommodation portion (255) is disposed in the first area.

11. The electronic device (100) of claim 9, wherein the at least one accommodation portion (255) comprises:
a first accommodation portion (255) disposed in a first direction from the space in which the TIM (230) is disposed; and
a second accommodation portion disposed in a second direction opposite to the first direction from the space in which the TIM (230) is disposed.

12. The electronic device (100) of claim 1, wherein the partition member (250) comprises at least one of a porous material or an oil-sorbent material.

13. A method of manufacturing an electronic device (100), the method comprising:
disposing (801), on a circuit board (260), a semiconductor component (210) and a shield can (220) disposed to surround at least a portion of the semiconductor component (210) and including an opening (221);
disposing (803) a thermal interface material, TIM (230), on at least a portion of the semiconductor component (210) viewed in a direction in which the semiconductor component (210) is viewed through the opening (221);
disposing (805) a partition member (250), on a surface of the semiconductor component (210) facing away from the circuit board (260), to block at least a partial area of the semiconductor component (210) in which the TIM (230) is disposed, from at least a portion of an area, in which the semiconductor component (210) is not disposed, in a direction along the surface, of the semiconductor component (210), on which the partition member (250) is disposed, and a shield sheet (240) to cover the opening (221); and
applying (807) the TIM (230) to a space at least partially surrounded by the semiconductor component (210), the partition member (250), and the shield sheet (240) by pressing at least a portion of the shield sheet (240) corresponding to the area in which the TIM (230) is disposed,
wherein the applying of the TIM (230) further comprises pressing at least a portion of the shield sheet (240) corresponding to the area in which the TIM (230) is disposed so that at least some of the TIM (230) applied to the space is discharged from an interior of the space to an exterior of the space through at least one hole leading from the interior of the space to the exterior of the space.

## Patentansprüche

1. Elektronische Vorrichtung (100), umfassend:
eine Leiterplatte (260);
eine auf der Leiterplatte (260) angeordnete Abschirmdose (220), die eine Öffnung (221) beinhaltet;
eine Halbleiterkomponente (210), die in einem Raum angeordnet ist, der zumindest teilweise von der Leiterplatte (260) und der Abschirmdose (220) umgeben ist;
eine Abschirmplatte (240), die so angeordnet ist, dass sie die Öffnung (221) abdeckt und ein Blockiermaterial beinhaltet, das zumindest einige der von der Halbleiterkomponente (210) erzeugten elektromagnetischen Wellen blockiert;
ein Trennelement (250), das zwischen der Halbleiterkomponente (210) und der Abschirmplatte (240) angeordnet ist, und
ein Wärmeleitmaterial, TIM, (230), das in einem Raum angeordnet ist, der zumindest teilweise von der Halbleiterkomponente (210), dem Trennelement (250) und der Abschirmplatte (240) umgeben ist,
wobei das Trennelement (250) so konfiguriert ist, dass es den Raum, in dem sich das TIM (230) befindet, zumindest teilweise umgibt, und
wobei das Trennelement (250) mindestens ein Loch umfasst, das von einem Inneren des Raums, in dem das TIM (230) angeordnet ist, zu einem Äußeren des Raums, in dem das TIM (230) angeordnet ist, führt.

2. Elektronische Vorrichtung (100) nach Anspruch 1, wobei die Halbleiterkomponente (210) einen auf der Leiterplatte (260) angeordneten Prozessor und eine zwischen dem Prozessor und der Abschirmplatte (240) angeordnete Speichervorrichtung umfasst,
das Trennelement (250) zwischen der Speichervorrichtung und der Abschirmplatte (240) angeordnet ist, und
das TIM (230) im Raum angeordnet ist, der zumindest teilweise von der Speichervorrichtung, dem Trennelement (250) und der Abschirmplatte (240) umgeben ist.

3. Elektronische Vorrichtung (100) nach Anspruch 2, wobei das Trennelement (250) so angeordnet ist, dass es zumindest einen Abschnitt eines Randes der Speichervorrichtung umgibt.

4. Elektronische Vorrichtung (100) nach Anspruch 1, wobei die Halbleiterkomponente (210) einen auf der Leiterplatte (260) angeordneten Prozessor und eine zwischen dem Prozessor und der Abschirmplatte (240) angeordnete Speichervorrichtung umfasst,
das Trennelement (250) so angeordnet ist, dass es zumindest einen Abschnitt eines Außenumfangs der Speichervorrichtung zwischen einer Fläche des Prozessors, auf der die Speichervorrichtung angeordnet ist, und der Abschirmplatte (240) umgibt, und
das TIM (230) im Raum angeordnet ist, der zumindest teilweise von der Speichervorrichtung, dem Trennelement (250) und der Abschirmplatte (240) umgeben ist.

5. Elektronische Vorrichtung (100) nach Anspruch 1, wobei das Trennelement (250) mindestens einen Schlitz umfasst, der in mindestens einer Wand des Trennelements (250) vorgesehen ist, und
das mindestens eine Loch dadurch ausgebildet ist, dass es von der Halbleiterkomponente (210), dem mindestens einen Schlitz und der Abschirmplatte (240) umgeben ist.

6. Elektronische Vorrichtung (100) nach Anspruch 5, wobei das Trennelement (250) umfasst:
eine erste Wand, die an einer Position positioniert ist, die bei Betrachtung der Halbleiterkomponente (210) durch die Öffnung (221) um einen ersten Abstand von einem Ende der Öffnung (221) getrennt ist; und
eine zweite Wand, die an einer Position positioniert ist, die von einem anderen Ende der Öffnung (221) um einen zweiten Abstand beabstandet ist, der kleiner ist als der erste Abstand, bei Betrachtung der Halbleiterkomponente (210) durch die Öffnung (221), und
wobei die erste Wand den mindestens einen Schlitz umfasst.

7. Elektronische Vorrichtung (100) nach Anspruch 5, wobei der mindestens eine Schlitz umfasst:
einen ersten Schlitz, der in der mindestens einen Wand vorgesehen ist; und
einen zweiten Schlitz, der in einer Wand vorgesehen ist, die der mindestens einen Wand zugewandt ist.

8. Elektronische Vorrichtung (100) nach Anspruch 5, wobei das Trennelement (250) eine erste Länge von dem mindestens einen Schlitz bis zu einem Ende der mindestens einen Wand und eine zweite Länge von dem mindestens einen Schlitz bis zu einem anderen Ende der mindestens einen Wand aufweist, und
die erste Länge gleich der zweiten Länge ist.

9. Elektronische Vorrichtung (100) nach Anspruch 1, die ferner mindestens einen Aufnahmeabschnitt (255) umfasst, der mit dem Raum verbunden ist, in dem das TIM (230) angeordnet ist, und der konfiguriert ist, um einen Abschnitt des TIM (230) aufzunehmen.

10. Elektronische Vorrichtung (100) nach Anspruch 9, wobei ein anderer Bereich als der Raum, in dem das TIM (230) angeordnet ist, einen ersten Bereich und einen zweiten Bereich umfasst, bei dem ein Abstand vom Trennelement (250) zu einem Ende der Öffnung (221) kleiner ist als im ersten Bereich, und
der mindestens eine Aufnahmeabschnitt (255) im ersten Bereich angeordnet ist.

11. Elektronische Vorrichtung (100) nach Anspruch 9, wobei der mindestens eine Aufnahmeabschnitt (255) umfasst:
einen ersten Aufnahmeabschnitt (255), der in einer ersten Richtung von dem Raum, in dem das TIM (230) angeordnet ist, angeordnet ist; und
einen zweiten Aufnahmeabschnitt, der in einer zweiten Richtung, die der ersten Richtung entgegengesetzt ist, von dem Raum aus angeordnet ist, in dem das TIM (230) angeordnet ist.

12. Elektronische Vorrichtung (100) nach Anspruch 1, wobei das Trennelement (250) mindestens eines von einem porösen Material oder einem ölabsorbierenden Material umfasst.

13. Verfahren zum Herstellen einer elektronischen Vorrichtung (100), wobei das Verfahren Folgendes umfasst:
Anordnen (801), auf einer Leiterplatte (260), einer Halbleiterkomponente (210) und einer Abschirmdose (220), die so angeordnet ist, dass sie zumindest einen Abschnitt der Halbleiterkomponente (210) umgibt und eine Öffnung (221) umfasst;
Anordnen (803) eines Wärmeleitmaterials, TIM, (230) auf mindestens einem Abschnitt der Halbleiterkomponente (210), bei Betrachtung in einer Richtung, in der die Halbleiterkomponente (210) durch die Öffnung (221) betrachtet wird;
Anordnen (805) eines Trennelements (250), auf einer der Leiterplatte (260) abgewandten Fläche der Halbleiterkomponente (210), um zumindest einen Teilbereich der Halbleiterkomponente (210), in dem das TIM (230) angeordnet ist, von zumindest einem Abschnitt eines Bereichs zu blockieren, in dem die Halbleiterkomponente (210) nicht angeordnet ist, in einer Richtung entlang der Fläche der Halbleiterkomponente (210), auf der das Trennelement (250) angeordnet ist, sowie einer Abschirmplatte (240) zur Abdeckung der Öffnung (221); und
Anwenden (807) des TIM (230) auf einen Raum, der zumindest teilweise von der Halbleiterkomponente (210), dem Trennelement (250) und der Abschirmplatte (240) umgeben ist, indem zumindest ein Abschnitt der Abschirmplatte (240), der dem Bereich entspricht, in dem das TIM (230) angeordnet ist, gepresst wird,
wobei das Anwenden des TIM (230) ferner das Pressen mindestens eines Abschnitts der Abschirmplatte (240) umfasst, der dem Bereich entspricht, in dem das TIM (230) angeordnet ist, so dass zumindest ein Teil des TIM (230), der auf den Raum angewendet wurde, aus einem Inneren des Raums durch mindestens ein Loch, das vom Inneren des Raums zum Äußeren des Raums führt, zu einem Äußeren des Raums gelangt.

## Revendications

1. Dispositif électronique (100) comprenant :
une carte de circuit (260) ;
un boîtier de blindage (220) disposé sur la carte de circuit (260) et comprenant une ouverture (221) ;
un composant semi-conducteur (210) disposé dans un espace au moins partiellement entouré par la carte de circuit (260) et le boîtier de blindage (220) ;
une feuille de blindage (240) disposée de manière à recouvrir l'ouverture (221) et comprenant un matériau de blocage qui bloque au moins une partie des ondes électromagnétiques générées par le composant semi-conducteur (210) ;
un élément de séparation (250) disposé entre le composant semi-conducteur (210) et la feuille de blindage (240), et
un matériau d'interface thermique, TIM, (230), disposé dans un espace au moins partiellement entouré par le composant semi-conducteur (210), l'élément de séparation (250) et la feuille de blindage (240),
dans lequel l'élément de séparation (250) est configuré pour entourer au moins partiellement l'espace dans lequel est disposé le TIM (230), et
dans lequel l'élément de séparation (250) comprend au moins un trou reliant un intérieur de l'espace dans lequel est disposé le TIM (230) à un extérieur de l'espace dans lequel est disposé le TIM (230).

2. Dispositif électronique (100) de la revendication 1, dans lequel le composant semi-conducteur (210) comprend un processeur disposé sur la carte de circuit (260), et un dispositif de mémoire disposé entre le processeur et la feuille de blindage (240),
l'élément de séparation (250) est disposé entre le dispositif de mémoire et la feuille de blindage (240), et
le TIM (230) est disposé dans l'espace au moins partiellement entouré par le dispositif de mémoire, l'élément de séparation (250) et la feuille de blindage (240).

3. Dispositif électronique (100) de la revendication 2, dans lequel l'élément de séparation (250) est disposé de manière à entourer au moins une partie d'un bord du dispositif de mémoire.

4. Dispositif électronique (100) de la revendication 1, dans lequel le composant semi-conducteur (210) comprend un processeur disposé sur la carte de circuit (260), et un dispositif de mémoire disposé entre le processeur et la feuille de blindage (240),
l'élément de séparation (250) est disposé de manière à entourer au moins une partie d'une périphérie extérieure du dispositif de mémoire, entre une surface du processeur sur laquelle est disposé le dispositif de mémoire et la feuille de blindage (240), et
le TIM (230) est disposé dans l'espace au moins partiellement entouré par le dispositif de mémoire, l'élément de séparation (250) et la feuille de blindage (240).

5. Dispositif électronique (100) de la revendication 1, dans lequel l'élément de séparation (250) comprend au moins une fente prévue dans au moins une paroi de l'élément de séparation (250), et
l'au moins un trou est formé en étant entouré par le composant semi-conducteur (210), l'au moins une fente et la feuille de blindage (240).

6. Dispositif électronique (100) de la revendication 5, dans lequel l'élément de séparation (250) comprend :
une première paroi disposée à une position séparée d'une extrémité de l'ouverture (221) par une première distance lorsque le composant semi-conducteur (210) est vu à travers l'ouverture (221) ; et
une deuxième paroi disposée à une position espacée d'une autre extrémité de l'ouverture (221) par une deuxième distance inférieure à la première distance lorsque le composant semi-conducteur (210) est vu à travers l'ouverture (221), et
dans lequel la première paroi comprend l'au moins une fente.

7. Dispositif électronique (100) de la revendication 5, dans lequel l'au moins une fente comprend :
une première fente prévue dans l'au moins une paroi ; et
une deuxième fente prévue dans une paroi faisant face à l'au moins une paroi.

8. Dispositif électronique (100) de la revendication 5, dans lequel l'élément de séparation (250) présente une première longueur allant de l'au moins une fente à une extrémité de l'au moins une paroi, et une deuxième longueur allant de l'au moins une fente à une autre extrémité de l'au moins une paroi, et
la première longueur est égale à la deuxième longueur.

9. Dispositif électronique (100) de la revendication 1, comprenant en outre au moins une partie de logement (255) reliée à l'espace dans lequel est disposé le TIM (230) et configurée pour loger une partie du TIM (230).

10. Dispositif électronique (100) de la revendication 9, dans lequel une zone autre que l'espace dans lequel est disposé le TIM (230) comprend une première zone et une deuxième zone présentant une distance plus courte entre l'élément de séparation (250) et une extrémité de l'ouverture (221) que celle de la première zone, et
l'au moins une partie de logement (255) est disposée dans la première zone.

11. Dispositif électronique (100) de la revendication 9, dans lequel l'au moins une partie de logement (255) comprend :
une première partie de logement (255) disposée dans une première direction à partir de l'espace dans lequel est disposé le TIM (230) ; et
une deuxième partie de logement disposée dans une deuxième direction opposée à la première direction, à partir de l'espace dans lequel est disposé le TIM (230).

12. Dispositif électronique (100) de la revendication 1, dans lequel l'élément de séparation (250) comprend au moins l'un d'un matériau poreux ou d'un matériau absorbant l'huile.

13. Procédé de fabrication d'un dispositif électronique (100), le procédé comprenant :
disposer (801), sur une carte de circuit (260), un composant semi-conducteur (210) et un boîtier de blindage (220) disposé de manière à entourer au moins une partie du composant semi-conducteur (210) et comprenant une ouverture (221) ;
disposer (803) un matériau d'interface thermique, TIM, (230) sur au moins une partie du composant semi-conducteur (210), vu dans une direction dans laquelle le composant semi-conducteur (210) est observé à travers l'ouverture (221) ;
disposer (805) un élément de séparation (250), sur une surface du composant semi-conducteur (210) faisant face à l'opposé de la carte de circuit (260), afin de bloquer au moins une zone partielle du composant semi-conducteur (210) sur laquelle est disposé le TIM (230) d'au moins une partie d'une zone, sur laquelle le composant semi-conducteur (210) n'est pas disposé, dans une direction le long de la surface du composant semi-conducteur (210) sur laquelle l'élément de séparation (250) est disposé, et une feuille de blindage (240) destinée à couvrir l'ouverture (221) ; et
appliquer (807) le TIM (230) dans un espace au moins partiellement entouré par le composant semi-conducteur (210), l'élément de séparation (250) et la feuille de blindage (240) en appuyant sur au moins une partie de la feuille de blindage (240) correspondant à la zone dans laquelle le TIM (230) est disposé,
dans lequel l'application du TIM (230) comprend en outre le pressage d'au moins une partie de la feuille de blindage (240) correspondant à la zone dans laquelle le TIM (230) est disposé, de sorte qu'au moins une partie du TIM (230) appliqué dans l'espace, est évacué d'un intérieur de l'espace vers un extérieur de l'espace par au moins un trou menant de l'intérieur de l'espace vers l'extérieur de l'espace.
